# EUROPÄISCHE PATENTSCHRIFT

(11) **EP 3 469 703 B1**
(45) Veröffentlichungstag und Bekanntmachung des Hinweises auf die Patenterteilung: **29.07.2020**
(21) Anmeldenummer: 17737204.2
(22) Anmeldetag: 09.06.2017
(51) Int. Cl.: H02N 2/00

(54) **ULTRASCHALLMOTOR**
ULTRASONIC MOTOR
MOTEUR À ULTRASONS

(30) Priorität: 13.06.2016 DE 102016110771
(43) Veröffentlichungstag der Anmeldung: 17.04.2019
(73) Patentinhaber: Physik Instrumente (PI) GmbH & Co. KG, 76228 Karlsruhe (DE)
(72) Erfinder: WISCHNEWSKIY, Wladimir, 14712 Rathenow (DE); WISCHNEWSKI, Alexej, 76744 Wörth (DE)
(74) Vertreter: Grünecker Patent- und Rechtsanwälte PartG mbB
(86) Internationale Anmeldenummer: PCT/DE2017/100488
(87) Internationale Veröffentlichungsnummer: WO 2017/215704

(56) Entgegenhaltungen:
- EP-B1- 2 258 004
- WO-A1-2014/135675
- JP-B2- 4 043 497
- US-B2- 9 136 778

## Beschreibung

Die Erfindung betrifft einen Ultraschallmotor gemäß Anspruch 1.

Aus der EP 2 200 101 A1 ist ein Ultraschallmotor bekannt, bei welchem der Ultraschallaktor mit Hilfe mehrerer Federn gehalten ist, wobei eine der Federn im Wesentlichen parallel zur Bewegungsrichtung des anzutreibenden Elements wirkt. Bei diesem bekannten Ultraschallmotor tritt zu Beginn der Bewegung des anzutreibenden Elements und auch im Moment des Stoppens der Bewegung eine Verschiebung des Ultraschallaktors auf, was die Positioniergenauigkeit des anzutreibenden Elements verringert.

Weiterhin ist aus der EP 2 258 004 B1 ein Ultraschallmotor bekannt, bei welchem der Ultraschallaktor an zwei seiner Seitenflächen durch Begrenzungsanschläge gehalten ist. Durch die Begrenzungsanschläge wird eine Verschiebung des Aktors beim Start und beim Stopp des anzutreibenden Elements wirksam unterbunden. Das Anpressen des Friktionselementes an das anzutreibende Element erfolgt hier - ebenso wie bei der oben zitierten EP 2 200 101 A1 - mit Hilfe zweier auf eine Seitenfläche des Aktors einwirkender unabhängiger Federn. Durch die Verwendung zweier unabhängig wirkender Federn ist es jedoch nicht möglich, exakt die gleiche Anpresskraft auf jede der Aktorseiten zu gewährleisten, was störenden Einfluss auf die Symmetrie des Motorbetriebs bei der Bewegung des anzutreibenden Elements in den beiden entgegengesetzt zueinander liegenden Antriebsrichtungen.

Es ist daher Aufgabe der Erfindung, einen Ultraschallmotor bereitzustellen, welcher einen symmetrischen Motorbetrieb bezüglich der Antriebsrichtungen ermöglicht und damit eine erhöhte Positioniergenauigkeit erzielt.

Diese Aufgabe wird gelöst durch einen Ultraschallmotor gemäß Anspruch 1, wobei die sich daran anschließenden Unteransprüche wenigstens zweckmäßige Weiterbildungen darstellen.

Demnach wird von einem Ultraschallmotor ausgegangen, der einen Aktor in Form einer piezoelektrischen Platte mit zwei flächenmäßig größten Hauptflächen und wenigstens vier die Hauptflächen miteinander verbindenden Seitenflächen umfasst, wobei an wenigstens einer der Seitenflächen mindestens ein Friktionselement angeordnet ist. Weiterhin umfasst der Ultraschallmotor ein anzutreibendes Element, das mit dem Friktionselement des Aktors in Wirkkontakt steht und über dieses angetrieben wird, eine Spannvorrichtung zum Anpressen des wenigstens einen Friktionselementes an das anzutreibende Element; und eine Thermokompensationsplattform mit Anlageabschnitten, an welchen die zugeordneten Seitenflächen des Aktors anliegen, so dass eine Verschiebung des Aktors nur entlang der anliegenden Seitenflächen möglich ist.

Der erfindungsgemäße Ultraschallmotor ist insbesondere dadurch gekennzeichnet, dass die Spannvorrichtung zwei drehbar gelagerte Drehwinkelhebel aufweist, wobei jeder Drehwinkelhebel einen Zughebelarm und einen Druckhebelarm umfasst, und die beiden Zughebelarme über eine gespannte Zugfeder miteinander verbunden sind, so dass eine Zugkraft auf jeden der Drehwinkelhebel ausgeübt ist. Diese Zugkraft der Zugfeder, die an einem distalen Abschnitt des jeweiligen Zughebelarms angreift, bringt ein Drehmoment in die Drehwinkelhebel dergestalt ein, dass jeder der Druckhebelarme mit einer definierten Kraft auf diejenige Seitenfläche des Aktors einwirkt, die der Seitenfläche gegenüberliegt, an welcher das mindestens eine Friktionselement angeordnet ist, so dass der Aktor entlang den Anlageabschnitten und linear geführt durch diese in Richtung des anzutreibenden Elements gedrückt ist.

Es kann von Vorteil sein, dass die Länge der Thermokompensationsplattform und deren Material so ausgewählt sind, dass ihre temperaturbedingte Längenänderung gleich der Summe der temperaturbedingten Längenänderung der piezoelektrischen Platte und der temperaturbedingten Breitenänderung der Anlageabschnitte ist, so dass bei Temperaturänderungen der Aktor im Wesentlichen frei ist von Kompressionskräften. Der Begriff ,Längenänderung' bezeichnet dabei die Dimensionsänderung in Richtung bzw. entlang der größten geometrischen Erstreckung der Thermokompensationsplattform und der piezoelektrischen Platte, nämlich deren Länge. Der Begriff 'Breitenänderung' bezeichnet hingegen die Dimensionsänderung in einer Richtung, die senkrecht zur größten geometrischen Erstreckung der Anlageabschnitte verläuft. Diese Richtung deckt sich im Wesentlichen mit der Längenrichtung der Thermokompensationsplattform und der piezoelektrischen Platte.

Ebenso kann es von Vorteil sein, dass jeder der Anlageabschnitte einen Basisabschnitt und zwei Flügelabschnitte mit jeweils einem freien Ende aufweist, an welchen der Aktor mit seiner entsprechenden bzw. zugeordneten Seitenfläche anliegt, wobei die Flügelabschnitte über einen Verbindungssteg, vorzugsweise über einen gemeinsamen Verbindungssteg, mit dem Basisabschnitt verbunden sind.

Zudem kann es von Vorteil sein, dass jeder der Anlageabschnitte einen Basisabschnitt und zwei Wandabschnitte aufweist, an welchem der Aktor mit seiner entsprechenden bzw. zugeordneten Seitenfläche anliegt, wobei jeder der Wandabschnitte über wenigstens einen Verbindungssteg, vorzugsweise über einen gemeinsamen Verbindungssteg, und einen Befestigungssteg mit dem Basisabschnitt verbunden ist.

Ferner kann es von Vorteil sein, dass die Resonanzfrequenz Fs zumindest eines Flügelabschnitts oder zumindest eines Wandabschnitts gleich oder größer als die Arbeitsfrequenz Fa des Aktors ist.

Außerdem kann es von Vorteil sein, dass der Aktor in Bezug auf die Anlageabschnitte dergestalt angeordnet ist, dass jeder Verbindungssteg und/oder jeder Befestigungssteg im Bereich des jeweiligen Geschwindigkeitsminimums der sich an der jeweiligen Seitenfläche des Aktors während des Betriebs ausbildenden Deformationsschwingungen liegt.

Darüber hinaus kann es von Vorteil sein, dass der Aktor in Bezug auf die Drehwinkelhebel dergestalt angeordnet ist, dass der jeweilige Punkt des Kontaktes zwischen einem der Druckhebelarme und dem Aktor im Bereich des jeweiligen Geschwindigkeitsminimums der sich an der jeweiligen Seitenfläche des Aktors während des Betriebs ausbildenden Deformationsschwingungen liegt.

Bei den vorgenannten vorteilhaften Anordnungen des Aktors erfährt dieser die geringsten Störungen hinsichtlich der bzw. den geringsten Einfluss auf die in ihm während seines Betriebs induzierten Deformationsschwingungen, so dass eine hohe Effektivität des Aktors resultiert.

Es zeigen:
Fig. 1: Explosionsdarstellung einer Ausführungsform eines erfindungsgemäßen Ultraschallmotors
Fig. 2: Explosionsdarstellung einer weiteren Ausführungsform eines erfindungsgemäßen Ultraschallmotors
Fig. 3: Darstellung 15: Vorderseitenansicht eines Aktors eines erfindungsgemäßen Ultraschallmotors; Darstellung 16: Rückseitenansicht des Aktors gemäß Darstellung 15; Darstellung 17: Blockschaltbild zur Darstellung einer möglichen Verbindung des Aktors gemäß den Darstellungen 15 und 16 in einem erfindungsgemäßen Ultraschallmotor mit einer elektrischen Erregervorrichtung
Fig. 4: Darstellungen 31 und 32: Berechnete Deformationszustände eines Aktors eines erfindungsgemäßen Ultraschallmotors; Darstellung 33: Berechnete Bewegungsbahnen der Seitenflächenpunkte eines Aktors eines erfindungsgemäßen Ultraschallmotors
Fig. 5: Darstellung 34: Ultraschallmotor gemäß Fig. 1 im zusammengesetzten Zustand; Darstellung 35: Schnitt durch den Ultraschallmotor gemäß Darstellung 34 an einer ersten Stelle; Darstellung 36: Schnitt durch den Ultraschallmotor gemäß Darstellung 34 an einer zweiten Stelle
Fig. 6: Darstellungen 37 und 40: Ausführungsformen eines Anlageabschnitts eines erfindungsgemäßen Ultraschallmotors
Fig. 7: Darstellung 64: Lage der Resonanzfrequenz Fs der ersten Mode der Biegeschwingungen der Flügelabschnitte bzw. der Wandabschnitte im Vergleich zur Arbeitsfrequenz Fa des Aktors; Darstellungen 45 und 46: berechnete Deformationen der Flügelabschnitte des Anlageabschnitts gemäß Darstellung 37; Darstellungen 47 und 48: berechnete Deformationen des Wandabschnitts des Anlageabschnitts gemäß Darstellung 40
Fig. 8: Darstellung 49: Prinzipskizze eines erfindungsgemäßen Ultraschallmotors in Seitenansicht zur Verdeutlichung der auf den Aktor einwirkenden Anpresskräfte; Darstellung 50: Draufsicht auf den Ultraschallmotor gemäß Darstellung 49 zur Verdeutlichung der thermischen Ausdehnung seiner Teile
Fig. 9: Darstellung 56: perspektivische Ansicht einer Ausführungsform eines Aktors eines erfindungsgemäßen Ultraschallmotors; Darstellung 57: Vorderseitenansicht des Aktors gemäß Darstellung 56; Darstellung 58: Rückseitenansicht des Aktors gemäß Darstellung 56; Darstellung 59: Blockschaltbild zur Verdeutlichung einer möglichen Verbindung des Aktors gemäß den Darstellungen 56 bis 58 in einem erfindungsgemäßen Ultraschallmotor mit einer elektrischen Erregervorrichtung
Fig. 10: Explosionsdarstellung eines erfindungsgemäßen Ultraschallmotors mit einem Aktor gemäß Fig. 9
Fig. 11: Darstellung 60: perspektivische Ansicht einer Ausführungsform eines Aktors eines erfindungsgemäßen Ultraschallmotors; Darstellung 61: Vorderseitenansicht des Aktors gemäß Darstellung 60; Darstellung 62: Rückseitenansicht des Aktors gemäß Darstellung 60; Darstellung 63: Blockschaltbild zur Verdeutlichung einer möglichen Verbindung des Aktors gemäß den Darstellungen 60 bis 62 in einem erfindungsgemäßen Ultraschallmotor mit einer elektrischen Erregervorrichtung
Fig. 12: Explosionsdarstellung eines erfindungsgemäßen Ultraschallmotors mit einem Aktor gemäß Fig. 11

Im Folgenden werden die Begriffe ,Ultraschallmotor' und ,Motor' in synonymer Weise benutzt. Das Gleiche gilt für die Begriffspaare 'Ultraschallaktor' und 'Aktor', bzw. 'Thermokompensationsplattform' und 'Plattform'.

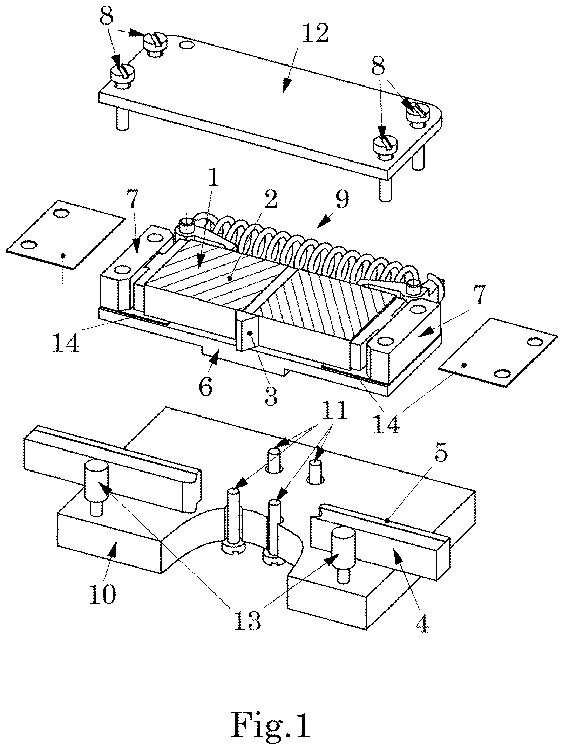

Figur 1 zeigt eine Ausführungsform eines erfindungsgemäßen Ultraschallmotors für eine Linearbewegung. Der Ultraschallmotor umfasst hierbei einen Ultraschallaktor 1 in Form einer rechteckigen piezoelektrischen Platte 2 mit zwei flächenmäßig größten Hauptflächen und vier die beiden Hauptflächen miteinander verbindenden Seitenflächen. An einer der Seitenflächen ist ein Friktionselement 3 angeordnet, das für den Friktionskontakt mit einer Friktionsschicht 5 eines stabförmigen anzutreibenden Elements 4 vorgesehen ist. Es ist zu beachten, dass das anzutreibende Element 4 in Fig. 1 mit einer Unterbrechung dargestellt ist.

Der Ultraschallmotor umfasst weiterhin eine Thermokompensationsplattform 6 mit Anlageabschnitten 7, an welchen sich der Aktor mit seinen entsprechenden bzw. zugeordneten Seitenflächen abstützt und der Aktor durch die Anlageabschnitte linear geführt ist. Die Anlageabschnitte 7 sind über Schrauben 8 an der Thermokompensationsplattform 6 befestigt, während die Thermokompensationsplattform 6 selbst auf dem Motor- oder Gerätegehäuse 10 mittels Befestigungselementen 11 montiert ist. Das Friktionselement 3 ist mit Hilfe der Spannvorrichtung 9 an die Friktionsschicht 5 des anzutreibenden Elements 4 angepresst. Eine mögliche Querverschiebung des Aktors 1, d.h. eine Verschiebung entlang der Flächennormale der Hauptflächen, wird durch die Abdeckung 12 verhindert bzw. begrenzt. Das anzutreibende Element 4 ist durch an dem Gehäuse 10 angeordnete Lager 13 beweglich gelagert. Isolierende Zwischenlager 14 isolieren den Aktor 1 von der Plattform 6 oder von der Abdeckung 12 elektrisch und/oder akustisch.

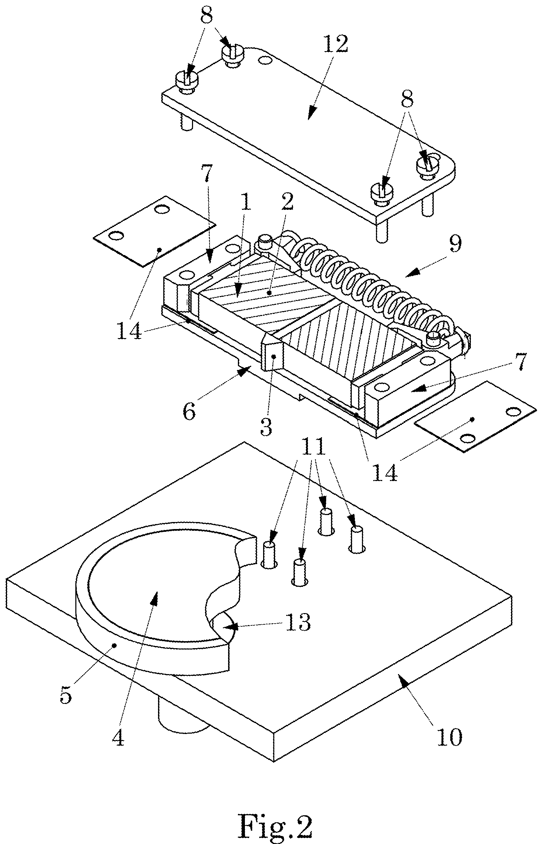

Fig. 2 zeigt eine mögliche Ausführungsform eines erfindungsgemäßen Ultraschallmotors für eine rotatorische Bewegung, bei welchem das anzutreibende Element 4 als runde Scheibe ausgeführt ist. Andere Ausführungsformen des anzutreibenden Elements, etwa in Form eines Zylinders oder einer Welle, sind hierbei ebenso denkbar.

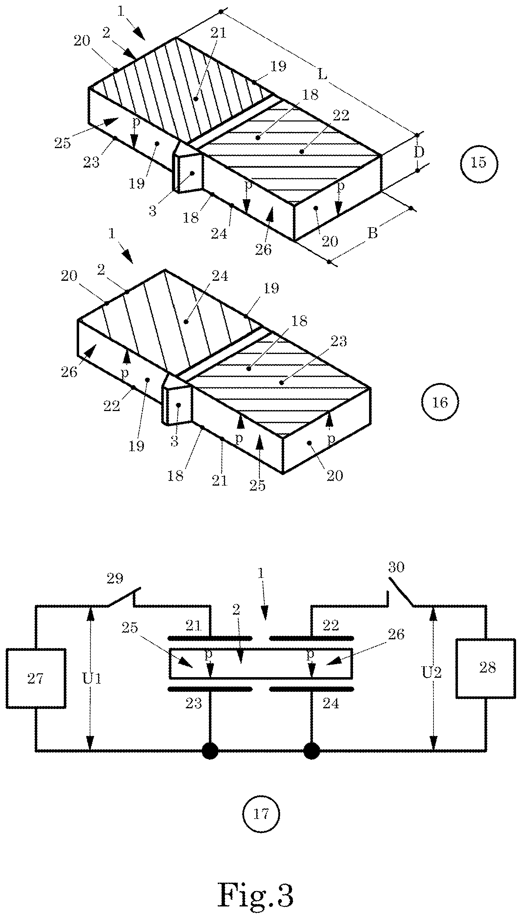

Die Darstellungen 15 und 16 von Fig. 3 zeigen die Vorder- oder Oberseite und die Rück- bzw. Unterseite eines Aktors 1 eines erfindungsgemäßen Ultraschallmotors. Die piezoelektrische Platte 2 des Aktors 1 hat die Hauptflächen 18 und die Seitenflächen 19 und 20. Die piezoelektrische Platte 2 hat weiterhin die Länge L, die Breite B und die Dicke D. Auf den Hauptflächen 18 befinden sich die Erregerelektroden 21, 22 und die allgemeinen Elektroden 23, 24. Die allgemeinen Elektroden 23 und 24 können dabei als gemeinsame Elektrode ausgeführt sein. Die Elektrodenpaare 21, 23 und 22, 24 mit dem zwischen ihnen angeordneten piezokeramischen Material bilden die Generatoren für die akustischen Stehwellen 25 und 26. Die Generatoren 25, 26 können auch in Form von Mehrschichtstrukturen ausgeführt werden, in denen die Schichten der Elektroden 21, 23 und 22, 24 und die Piezokeramikschichten untereinander abwechselnd angeordnet sind (in Fig. 3 nicht dargestellt). Auf einer der Seitenflächen 19 der Platte 2 des Aktors 1 ist das Friktionselement 3 angeordnet. Gemäß Darstellung 17 von Fig. 3, welche ein Blockschaltbild einer möglichen Ansteuerungsvariante des Aktors gemäß den Darstellungen 15 und 16 zeigt, ist der Aktor 1 mit einer elektrischen Erregervorrichtung umfassend einen Generator 27 für die elektrische Wechselspannung U1 und einen Generator 28 für die elektrische Wechselspannung U2 elektrisch verbunden, wobei die Wechselspannungen U1 und U2 die gleiche, der Betriebsfrequenz Fa des Aktors 1 entsprechende Frequenz, aufweisen. Das Anlegen der Spannung U1 und U2 an den Aktor 1 erfolgt über die Schalter 29 und 30.

Je nach gewünschtem Betriebsmodus des Aktors kann an die Elektroden 21 und 23 oder 22 und 24 der Generatoren 25 und 26 lediglich die Spannung U1 oder lediglich die Spannung U2 angelegt werden. In diesem Fall wird im Aktor 1 mit den Generatoren 25 und 26 nur eine akustische Stehwelle generiert. Die Länge der erzeugten Wellen ist in etwa gleich der Länge der piezoelektrischen Platte L des Aktors1. Das bedeutet, dass im Aktor 1 die zweite Mode der akustischen Welle erzeugt wird. Außerdem können an die Elektroden 21, 23 und 22, 24 die zwei Spannungen U1 und U1 angelegt werden. In diesem Fall werden im Aktor 1 mit den Generatoren 25 und 26 zwei zueinander phasenverschobene akustische Stehwellen der Länge L generiert. Die elektrische Erregervorrichtung kann auch nur aus einem Generator 27 für die elektrische Spannung U1 bestehen. Diese Spannung kann an die Elektroden 21 und 23 des Generators 25 oder an die Elektroden 22 und 24 des Generators 26 angelegt werden.

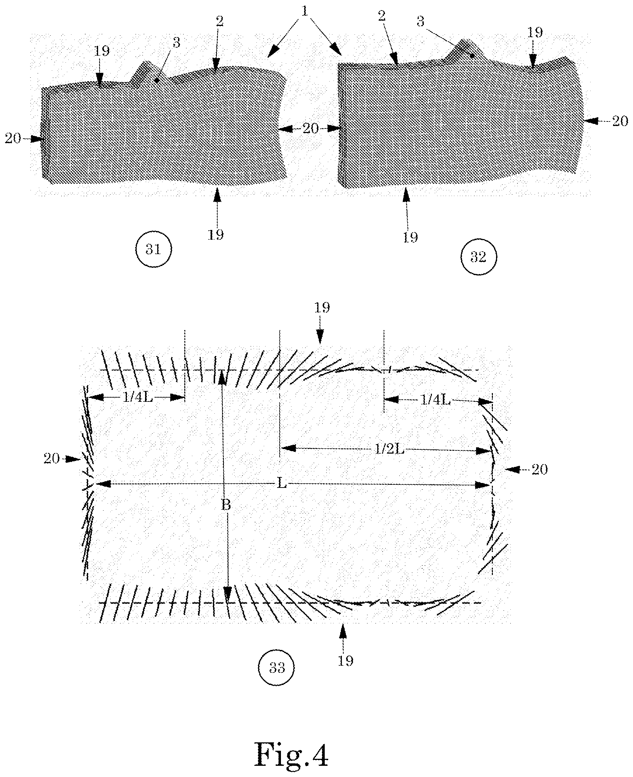

Wird in dem Aktor 1 eine akustische Stehwelle mit seiner Betriebsfrequenz Fa erzeugt, schwingt der Aktor 1 gemäß der in den Darstellungen 31 und 32 von Fig. 4 gezeigten Weise. Dabei bewegen sich die Materialpunkte der Seitenflächen 19 und 20 auf den in Darstellung 33 gezeigten Bewegungsbahnen. Hierbei ist erkennbar, dass in den zentralen Abschnitten (d.h. bei L/2) der Seitenflächen 19 die maximalen Schwingungsamplituden auftreten, d.h. die Maxima der Schwingungsgeschwindigkeiten der Materialpunkte der Seitenflächen 19. In einer Entfernung von etwa 1/4L von den Seitenflächen 20 befinden sich die minimalen Schwingungsamplituden, d.h. die Minima der Schwingungsgeschwindigkeiten. In den zentralen Abschnitten (d.h. bei B/2) der Seitenflächen 20 befinden sich die minimalen Schwingungsamplituden oder die minimalen Schwingungsgeschwindigkeiten der Materialpunkte der Seitenflächen 20. Da das Friktionselement 3 im Maximum der Schwingungsgeschwindigkeiten der Seitenfläche 19 angeordnet ist, bewegt es sich auf einer maximalen linearen Bewegungsbahn und überträgt dabei an das anzutreibende Element 4 die maximale Antriebskraft und versetzt damit das anzutreibende Element 4 in Bewegung. Wenn in dem Aktor 1 zwei akustische Stehwellen erzeugt werden, kann die Bewegungsbahn der Materialpunkte der Flächen 19 und 20 die Form einer Ellipse aufweisen.

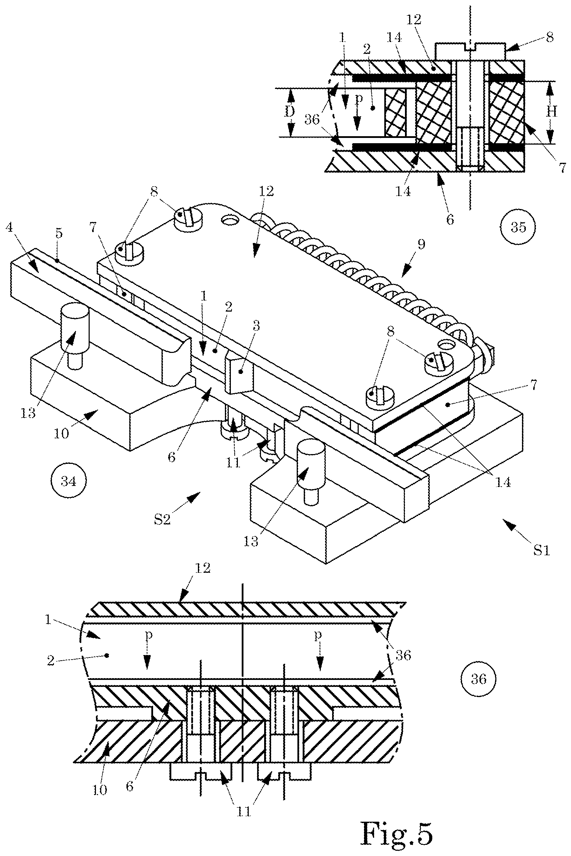

Die Darstellung 34 von Fig. 5 zeigt den Ultraschallmotor gemäß Fig. 1 in zusammengesetzter Weise. Darstellung 35 von Fig. 5 zeigt einen Schnitt durch Teile des Motors in Höhe der Schrauben 8 in einer senkrecht zur Richtung S1 verlaufenden Ebene. Durch die Schrauben 6 werden die Anlageabschnitte 7 an die peripheren Seiten der Thermokompensationsplattform 6 angepresst. Die Höhe H der Anlageabschnitte 7 ist etwa 0,2 bis 0,3 mm größer als die Dicke D der piezoelektrischen Platte 2. Im Ergebnis entstehen sowohl zwischen der Platte 2 und der Plattform 6 als auch zwischen der Platte 2 und der Abdeckung 12 die Abstände 36. Durch diese Abstände 36 ist es den Schrauben 8 möglich, die Anlageabschnitte 7 zu fixieren, ohne die Platte 2 zwischen der Plattform 6 und der Abdeckung 12 einzuklemmen. Darstellung 36 von Fig. 5 zeigt einen Schnitt durch Teile des Motors in Höhe der Schrauben der Befestigungselemente 11 in der senkrecht zur Richtung S2 verlaufenden Ebene. Die Befestigungselemente 11 befinden sich im zentralen Abschnitt der Thermokompensationsplattform 6 und dienen der Fixierung des Motors auf dem Gehäuses 10 oder einer Apparatur. Als Befestigungselemente können Gewindebohrungen und Schrauben, gewindefreie Bohrungen und Stifte oder andere geeignete Befestigungselemente verwendet werden.

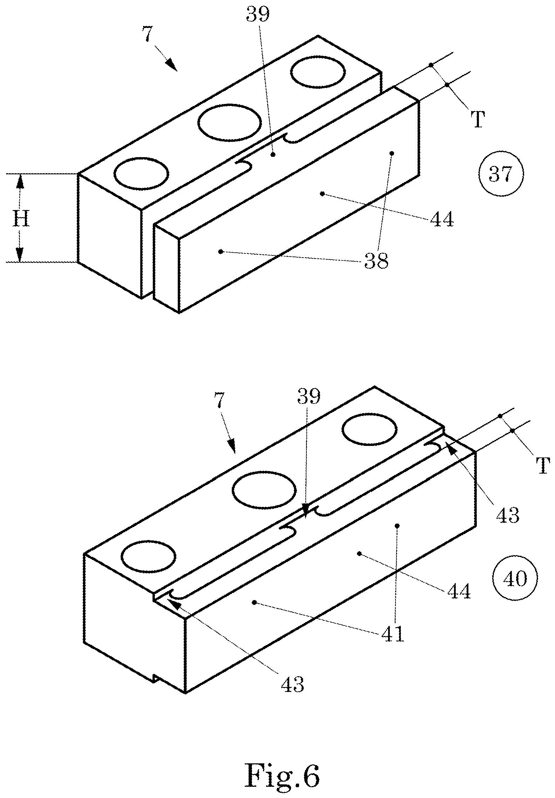

Die Darstellung 37 von Fig. 6 zeigt eine mögliche Ausführungsform eines Anlageabschnitts 7, wobei dieser einen Basisabschnitt mit Durchgangslöchern und Flügelabschnitte 38 aufweist, welche über einen gemeinsamen Verbindungssteg 39 mit dem Basisabschnitt integral oder einstückig verbunden sind. Die Flügelabschnitte 38 sind somit nur einseitig befestigt und weisen einen freien und nicht befestigten distalen Abschnitt auf. Auf den Flügelabschnitten 38 ist eine Gleitfläche 44 angeordnet.

Darstellung 40 von Fig. 6 zeigt eine weitere mögliche Ausführungsform eines Anlageabschnitts 7, wobei dieser einen zu Darstellung 37 von Fig. 6 identischen Basisabschnitt aufweist, an welchem über einen Verbindungssteg 39 und zwei Befestigungsstege 43 in integraler bzw. einstückiger Weise zwei Wandabschnitte 41 verbunden sind. Die Wandabschnitte 41 haben somit im Gegensatz zu den Flügelabschnitten 38 gemäß Darstellung 37 von Fig. 6 keine freien bzw. nicht befestigte Abschnitte. Auf den Wandabschnitten 41 ist ebenfalls eine Gleitfläche 44 angeordnet.

Bei der Montage des Motors werden die Anlageabschnitte 7 mit ihren Gleitflächen 44 an die Stirnflächen der piezoelektrischen Platte 2 angepresst, um damit die Abstände zwischen den Flächen 20 und den Flächen 44 zu beseitigen. Anschließend werden die Anlageabschnitte 7 mit den Schrauben 8 auf der Plattform 6 derart fixiert, dass der Verbindungssteg 39 in dem Bereich der Seitenflächen 20 der Platte 2 zu liegen kommt, in welchem sich während des Betriebs die Minima der Schwingungsgeschwindigkeiten der Seitenflächen 20 aufgrund der im Aktor angeregten Deformationsschwingungen ausbilden. Der während seines Betriebs in Schwingungen versetzte Aktor 1 versetzt seinerseits mit seinen Seitenflächen 20 die Flügelabschnitte 38 bzw. die Wandabschnitte 44 in Schwingungen.

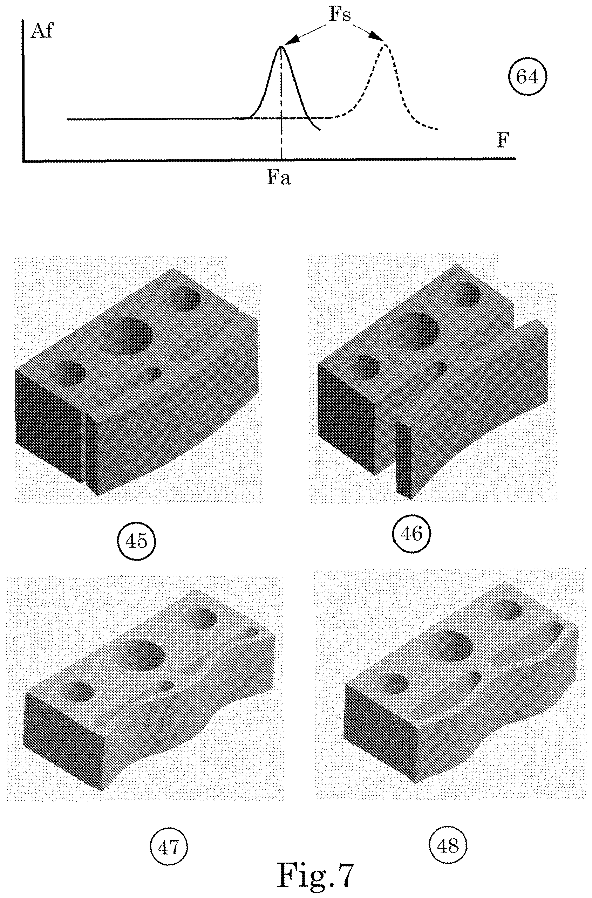

Die Dicke T der Flügelabschnitte 38 oder der Wandabschnitte 41 ist so gewählt, dass die Resonanzfrequenz Fs der ersten Mode der Biegeschwingungen der Flügelabschnitte 38 bzw. der Wandabschnitte 41, gleich oder größer als die Arbeitsfrequenz Fa des Aktors 1 ist, wie in Darstellung 64 von Fig. 7 gezeigt, wobei Af die Schwingungsamplitude der Flügelabschnitte 38 bzw. der Wandabschnitte 41 ist. Dabei schwingen die Flügelabschnitte 38 bzw. die Wandabschnitte 41 so, wie in den Darstellungen 45 bis 48 von Fig. 7 gezeigt.

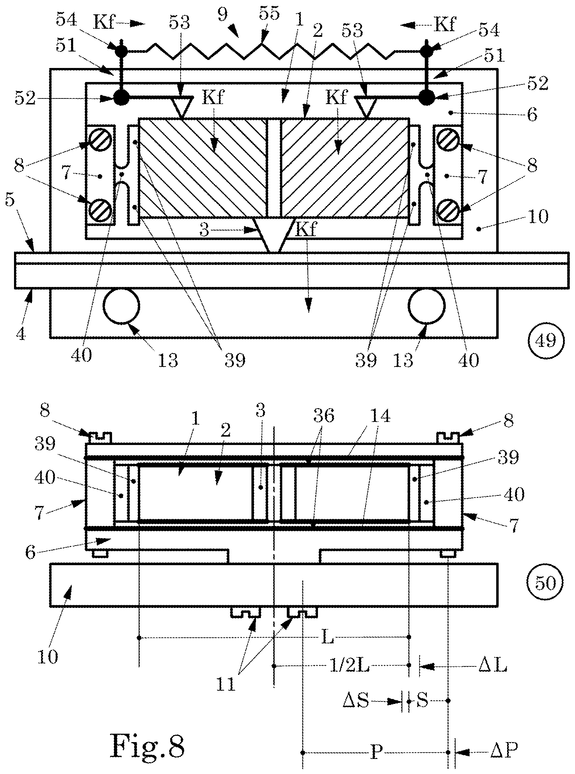

Darstellung 49 von Fig. 8 entspricht einer Prinzipskizze eines erfindungsgemäßen Ultraschallmotors in Seitenansicht zur Verdeutlichung der auf den Aktor einwirkenden Anpresskräfte, während Darstellung 50 von Fig. 8 einer Draufsicht auf den Ultraschallmotor gemäß Darstellung 49 zur Verdeutlichung der thermischen Ausdehnung seiner Teile entspricht. Das an dem Aktor 1 angeordnete Friktionselement 3 ist über die Spannvorrichtung 9, welche zwei auf den Achsen 52 montierte Drehwinkelhebel 51 umfasst, an die Friktionsschicht 5 des anzutreibenden Elements 4 angepresst. Jeder Drehwinkelhebel 51 weist einen Druckhebelarm 53 und einen Zughebelarm 54 auf. Die Druckhebelarme 53 haben Kontakt mit der Seitenfläche 9 des Aktors 1, und zwar in dem Bereich, in welchem sich beim Betrieb des Aktors ein Minimum der Deformationsschwingungsgeschwindigkeiten einstellt. Auf die Zughebelarme 54 wirken die beiden durch die Zugfeder 55 erzeugten und entgegengesetzt gerichteten gleich großen Kräfte Kf. Die an jedem Zughebelarm angreifende Kraft Kf generiert ein Drehmoment in dem jeweiligen Drehwinkelhebel, weshalb aufgrund der drehbaren Lagerung des Drehwinkelhebels jeder Druckhebelarm mit einer definierten Kraft auf die Seitenfläche 19 des Aktors 1 einwirkt.

Die Feder 55 mit der Zugkraft Kd=2Kf presst den Aktor 1 bzw. das Friktionselement 3 an die Friktionsoberfläche 5 des anzutreibenden Elements 4. Die Anpresskraft Kd setzt sich hierbei aus zwei gleichgroßen Kräften Kf zusammen. Die Besonderheit der Anpressvorrichtung 9 des erfindungsgemäßen Ultraschallmotors besteht darin, dass die Kräfte Kf stets gleich groß sind. Dies verhindert wirkungsvoll ein Verkanten des Aktors 1 zwischen den Anlageabschnitten 7.

Durch die während des Betriebs in den Flügelabschnitten 38 oder in den Wandabschnitten 41 der Anlageabschnitte 7 generierten Biegeschwingungen verringert sich die Reibungskraft zwischen der jeweiligen Gleitoberfläche 44 und der jeweiligen Stirnfläche 20 des Aktors 1 erheblich. Daher kann sich der Aktor 1 mit seinem Friktionselement 3 senkrecht zur Friktionsschicht 5 frei bewegen. Da sich die Verbindungsstege 39 bzw. die Befestigungsstege 43 in den Bereichen des Schwingungsgeschwindigkeitsminimums der Seitenflächen 20 des schwingenden Aktors 1 befinden, verringert sich die akustische Last auf den Aktor 1 seitens der Anlageabschnitte 7 deutlich. Dabei unterbinden die Anlageabschnitte 7 sicher eine Verschiebung des Aktor 1 parallel zur Friktionsschicht 5. Dies erhöht wesentlich die Positioniergenauigkeit des anzutreibenden Elements 4.

Erwärmt sich der Aktor 1, entweder durch den Betrieb des Ultraschallmotors selbst oder durch die Erhöhung der Umgebungstemperatur, dehnen sich der Aktor 1, die Anlageabschnitte 7 und die Thermokompensationsplattform 6 aus. Die temperaturbedingte Dehnung des Aktors um die halbe Länge L ist mit ΔL, die der Breite S der Anlageabschnitte 7 mit ΔS und die der Länge P der Plattform 6 mit ΔP gekennzeichnet (siehe Darstellung 50 von Fig. 8). Die Wärmeausdehnungen ΔL und ΔS erfolgen in zwei entgegengesetzten Richtungen und bewirken daher ohne eine Gegenmaßnahme eine Kompression des Aktors 1 zwischen den beiden Anlageabschnitten 7. Da die Thermokompensationsplattform 6 in ihrem zentralen Bereich gehalten ist und die Anlageabschnitte 7 an ihren peripheren Bereichen befestigt sind, wird die Temperaturausdehnung ΔP der Plattform 6 teilweise oder vollständig durch Temperaturausdehnung ΔS der Anlageabschnitte 7 kompensiert. Für eine vollständige Kompensation bzw. für eine vollständige Verhinderung der Kompression des Aktors 1 muss die Bedingung ΔP=ΔL+ΔS eingehalten werden. Bei der Einhaltung dieser Bedingung kommt es weder bei einem Anstieg, noch bei einem Abfall der Temperatur zu einer Kompression des Aktors 1. Um das angegebene Verhältnisses einzuhalten, ist es erforderlich, die Länge P der Plattform 6 unter Beachtung der Temperaturausdehnungskoeffizienten der Thermokompensationsplattform 6, des Aktors 1 und der Anlageabschnitte 7 auszuwählen.

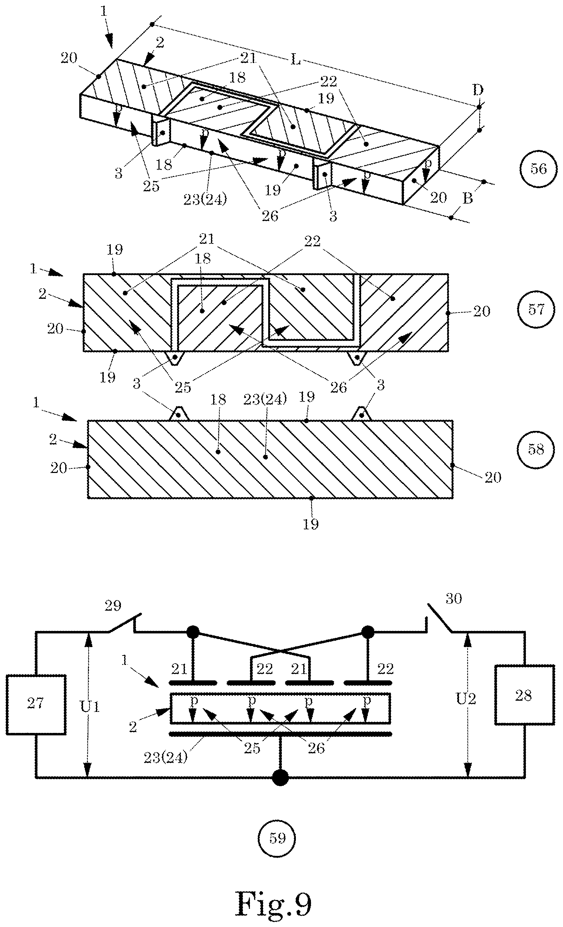

Darstellung 56 von Fig. 9 zeigt in perspektivischer Ansicht den Aufbau eines Aktors 1 eines erfindungsgemäßen Ultraschallmotors mit doppelter Länge L, in dem die vierte Mode einer akustischen Stehwelle erzeugt wird. Die Darstellungen 57 und 58 zeigen die Vorderseite und die Rückseite des Aktors 1 gemäß Darstellung 56. Darstellung 59 von Fig. 9 zeigt ein Blockschaltbild betreffend eine mögliche Verbindung/Ansteuerung des Aktors 1 gemäß den Darstellungen 56 bis 58 mit einer elektrischen Erregervorrichtung, durch welche in ihm die Ausbildung einer akustischen Welle hervorgerufen wird.

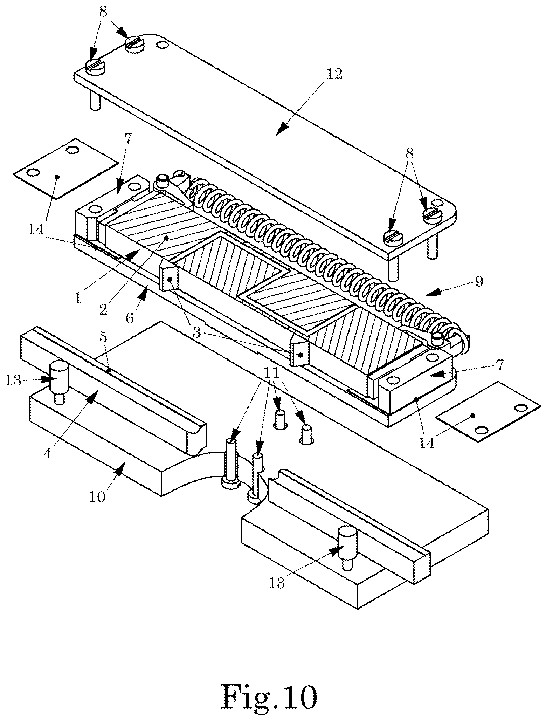

Fig. 10 zeigt in einer Explosionsdarstellung eine Ausführungsform des erfindungsgemäßen Ultraschallmotors mit dem Aktor gemäß Fig. 9.

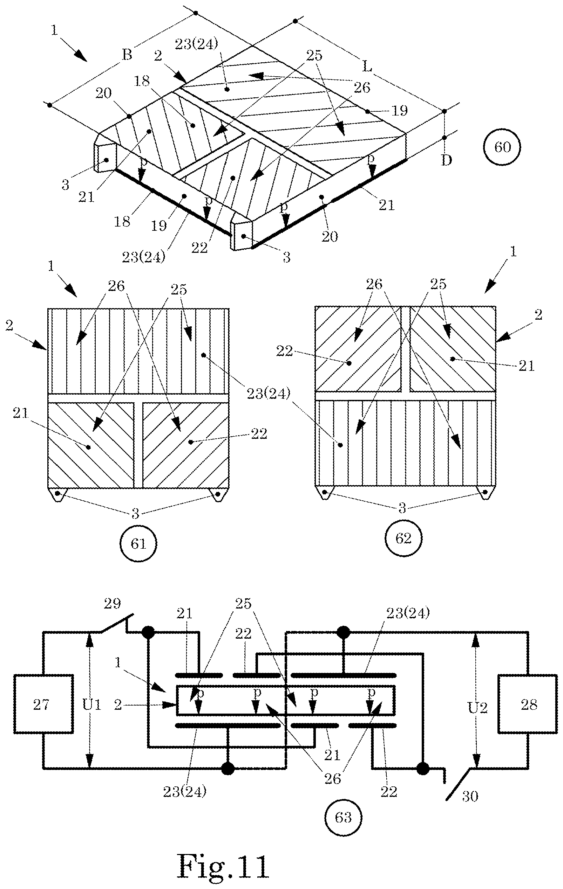

Darstellung 60 von Fig. 11 zeigt eine weitere Ausführungsform für einen Aktor 1 eines erfindungsgemäßen Ultraschallmotors in perspektivischer Ansicht. Der Aktor hat hierbei die Form einer quadratischen piezoelektrischen Platte 2, wobei die Länge L der piezoelektrischen Platte 2 gleich oder im Wesentlichen gleich ihrer Breite B ist. Die Darstellungen 61 und 62 von Fig. 11 zeigen die Vorderseite und die Rückseite des Aktors 1 gemäß Darstellung 60 von Fig. 11. Darstellung 63 von Fig. 11 zeigt das Blockschaltbild für eine mögliche Verbindung bzw. Ansteuerung des Aktors 1 gemäß den Darstellungen 60 bis 62 mit einer elektrischen Erregervorrichtung. In dem quadratischen Aktor wird hierbei entweder die zweite Mode einer diagonalen Welle längs einer Diagonale der piezoelektrischen Platte 2 angeregt, oder es werden zwei diagonale akustische Wellen längs der beiden Diagonalen der quadratischen Platte 2 generiert.

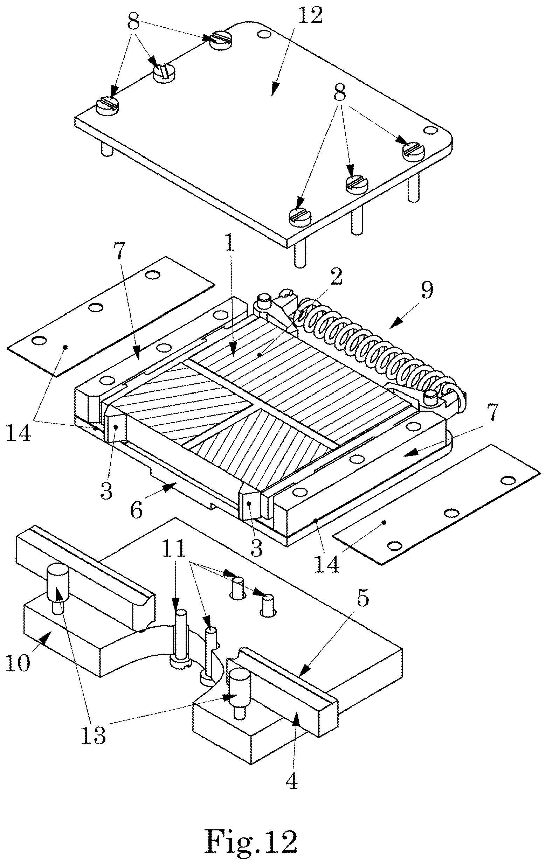

Fig. 12 zeigt in einer Explosionsdarstellung eine Ausführungsform des erfindungsgemäßen Ultraschallmotors mit dem Aktor gemäß Fig. 11.

## Patentansprüche

1. Ultraschallmotor, umfassend:
- einen Aktor (1) in Form einer piezoelektrischen Platte (2) mit zwei flächenmäßig größten Hauptflächen (18) und wenigstens vier die Hauptflächen miteinander verbindenden Seitenflächen (19, 20), wobei an wenigstens einer der Seitenflächen (19) mindestens ein Friktionselement (3) angeordnet ist;
- ein anzutreibendes Element (4), das mit dem Friktionselement (3) des Aktors (1) in Wirkkontakt steht und über dieses angetrieben wird;
- eine Spannvorrichtung (9) zum Anpressen des wenigstens einen Friktionselementes (3) an das anzutreibende Element (4); und
- eine Thermokompensationsplattform (6) mit Anlageabschnitten (7), an welchen die zugeordneten Seitenflächen (20) des Aktors (1) anliegen, so dass eine Verschiebung des Aktors (1) nur entlang der anliegenden Seitenflächen (20) möglich ist,
**dadurch gekennzeichnet, dass** die Spannvorrichtung (9) zwei Drehwinkelhebel (51) aufweist, wobei jeder Drehwinkelhebel (51) einen Zughebelarm (54) und einen Druckhebelarm (53) umfasst, und die beiden Zughebelarme (54) über eine gespannte Zugfeder (55) miteinander verbunden sind, und die Zugkraft der Zugfeder (55) ein Drehmoment auf die Drehwinkelhebel (51) dergestalt ausübt, dass jeder der Druckhebelarme (53) mit einer definierten Kraft auf diejenige Seitenfläche (19) des Aktors (1) einwirkt, die der Seitenfläche (19) gegenüberliegt, an welcher das mindestens eine Friktionselement (3) angeordnet ist, so dass der Aktor entlang den Anlageabschnitten (7) und linear geführt durch diese in Richtung des anzutreibenden Elements (4) gedrückt ist.

2. Ultraschallmotor nach Anspruch 1, **dadurch gekennzeichnet, dass** die Länge der Thermokompensationsplattform (6) und deren Material so ausgewählt sind, dass ihre temperaturbedingte Längenänderung gleich der Summe der temperaturbedingten Längenänderung der piezoelektrischen Platte (2) und der temperaturbedingten Breitenänderung der Anlageabschnitte (7) ist, so dass bei Temperaturänderungen der Aktor (1) im Wesentlichen frei von von außen einwirkenden Kompressionskräften ist.

3. Ultraschallmotor nach Anspruch 1 oder 2, **dadurch gekennzeichnet, dass** jeder der Anlageabschnitte (7) einen Basisabschnitt und zwei Flügelabschnitte (38) mit einem freien Ende aufweist, an welchen der Aktor (1) mit seiner entsprechenden Seitenfläche (20) anliegt, wobei die Flügelabschnitte (38) über einen Verbindungssteg (39), vorzugsweise über einen gemeinsamen Verbindungssteg, mit dem Basisabschnitt verbunden sind.

4. Ultraschallmotor nach Anspruch 1 oder 2, **dadurch gekennzeichnet, dass** jeder der Anlageabschnitte (7) einen Basisabschnitt und zwei Wandabschnitte (41) aufweist, an welchem der Aktor (1) mit seiner entsprechenden Seitenfläche (19) anliegt, wobei jeder Wandabschnitt (41) über wenigstens einen Verbindungssteg (39), vorzugsweise über einen gemeinsamen Verbindungssteg, und einen Befestigungssteg (43) mit dem Basisabschnitt verbunden ist.

5. Ultraschallmotor nach Anspruch 3 oder 4, **dadurch gekennzeichnet, dass** die Resonanzfrequenz Fs zumindest eines Flügelabschnitts (38) oder zumindest eines Wandabschnitts (41) gleich oder größer als die Arbeitsfrequenz Fa des Aktors (1) ist.

6. Ultraschallmotor nach einem der Ansprüche 3 bis 5, **dadurch gekennzeichnet, dass** der Aktor (1) in Bezug auf die Anlageabschnitte (7) dergestalt angeordnet ist, dass jeder Verbindungssteg (39) und/oder jeder Befestigungssteg (43) im Bereich des jeweiligen Geschwindigkeitsminimums der sich an der jeweiligen Seitenfläche (19) des Aktors (1) während des Betriebs ausbildenden Deformationsschwingungen liegt.

7. Ultraschallmotor nach einem der vorhergehenden Ansprüche, **dadurch gekennzeichnet, dass** der Aktor (1) in Bezug auf die Drehwinkelhebel (51) dergestalt angeordnet ist, dass der jeweilige Punkt des Kontaktes zwischen einem der Druckhebelarme (53) und dem Aktor (1) im Bereich des jeweiligen Geschwindigkeitsminimums der sich an der jeweiligen Seitenfläche (20) des Aktors (1) während des Betriebs ausbildenden Deformationsschwingungen liegt.

## Claims

1. Ultrasonic motor, comprising:
- an actuator (1) in the form of a piezo-electric plate (2) with two main surfaces (18) having the largest areas and at least four side surfaces (19, 20) connecting the main surfaces with one another, wherein at least one friction element (3) is arranged on at least one of the side surfaces (19);
- an element to be driven (4) which is in active contact with the friction element (3) of the actuator (1) and is driven via the same;
- a tensioning device (9) for pressing the at least one friction element (3) against the element to be driven (4);
- and a thermo-compensation platform (6) having abutting sections (7) against which the associated side surfaces (20) of the actuator (1) abut so that a displacement of the actuator (1) is only possible along the abutting side surfaces (20),
**characterized in that** the tensioning device (9) comprises two rotation angle levers (51), wherein each rotation angle lever (51) comprises one tension lever arm (54) and one pressure lever arm (53), and wherein the two tension lever arms (54) are connected to one another via a tensioned tension spring (55), and the tensile force of the tension spring (55) exerts a torque on the rotation angle lever (51) in such a way that each of the pressure lever arms (53) acts with a defined force on that side surface (19) of the actuator (1) which is opposite to the side surface (19) on which the at least one friction element (3) is arranged so that the actuator is pressed along the abutting sections (7) and linearly guided by them in the direction of the element to be driven (4).

2. Ultrasonic motor according to claim 1, **characterized in that** the length of the thermo-compensation platform (6) and its material are selected such that its temperature-related change in length is equal to the sum of the temperature-related change in length of the piezo-electric plate (2) and the temperature-related change in width of the abutting sections (7) so that the actuator (1) is substantially free of externally applied compression forces when the temperature changes.

3. Ultrasonic motor according to claim 1 or 2, **characterized in that** each of the abutting sections (7) has one base section and two wing sections (38), each with a free end, against which the actuator (1) abuts with its corresponding side surface (20), wherein the wing sections (38) are connected to the base section via a connecting web (39), preferably via a common connecting web.

4. Ultrasonic motor according to claim 1 or 2, **characterized in that** each of the abutting sections (7) has a base section and two wall sections (41) against which the actuator (1) abuts with its corresponding side surface (19), wherein each of the wall sections (41) is connected to the base section via at least one connecting web (39), preferably via a common connecting web, and a fastening web (43).

5. Ultrasonic motor according to claim 3 or 4, **characterized in that** the resonant frequency Fs of at least one wing section (38) or at least one wall section (41) is equal to or greater than the operating frequency Fa of the actuator (1).

6. Ultrasonic motor according to one of claims 3 to 5, **characterized in that** the actuator (1) is arranged with respect to the abutting sections (7) in such a way that each connecting web (39) and/or each fastening web (43) is located in the range of the respective velocity minimum of the deformation vibrations generated on the respective side surface (19) of the actuator (1) during operation.

7. Ultrasonic motor according to one of the preceding claims, **characterized in that** the actuator (1) is arranged with respect to the rotation angle levers (51) in such a way that the respective point of contact between one of the pressure lever arms (53) and the actuator (1) is in the range of the respective velocity minimum of the deformation vibrations generated on the respective side surface (20) of the actuator (1) during operation.

## Revendications

1. Moteur à ultrasons comprenant:
- un actionneur (1) sous la forme d'une plaque piézoélectrique (2) présentant deux surfaces principales (18) avec la plus grande surface et au moins quatre surfaces latérales (19, 20) reliant les surfaces principales entre elles, dans lequel au moins un élément de friction (3) est disposé sur au moins une des surfaces latérales (19);
- un élément (4) à entraîner, qui est en contact opérationnel avec l'élément de friction (3) de l'actionneur (1) et qui est entraîné par ce dernier;
- un dispositif de serrage (9) pour presser le ou les éléments de friction (3) contre l'élément (4) à entraîner; et
- une plate-forme de compensation thermique (6) avec des sections de butée (7) contre lesquelles butent les faces latérales associées (20) de l'actionneur (1), de sorte qu'un déplacement de l'actionneur (1) n'est possible que le long des faces latérales (20) en butée,
**caractérisé en ce que** le dispositif de serrage (9) présente deux leviers d'angle de rotation (51), chaque levier d'angle de rotation (51) comprenant un bras de levier de traction (54) et un bras de levier de poussée (53), et les deux bras de levier de traction (54) sont reliés entre eux par un ressort de traction (55) tendu, et la force de traction du ressort de traction (55) exerce de cette manière un couple sur les leviers d'angle de rotation (51), **en ce que** chacun des bras de levier de pression (53) agit avec une force définie sur la surface latérale (19) de l'actionneur (1) qui est opposée à la surface latérale (19) sur laquelle est disposé le au moins un élément de friction (3), de sorte que l'actionneur est pressé le long des sections de contact (7) et, guidé linéairement par celles-ci, en direction de l'élément (4) à entraîner.

2. Moteur à ultrasons selon la revendication 1, **caractérisé en ce que** la longueur de la plate-forme de compensation thermique (6) et son matériau sont choisis de telle sorte que sa variation de longueur liée à la température est égale à la somme de la variation de longueur liée à la température de la plaque piézoélectrique (2) et de la variation de largeur liée à la température des sections de butée (7), de sorte que l'actionneur (1) est essentiellement exempt de forces de compression agissant de l'extérieur en cas de variations de température.

3. Moteur à ultrasons selon la revendication 1 ou 2, **caractérisé en ce que** chacune des parties en butée (7) comprend une partie de base et deux parties d'aile (38) avec une extrémité libre, contre lesquelles l'actionneur (1) vient en butée avec sa surface latérale correspondante (20), dans lequel les parties d'aile (38) sont reliées à la partie de base par l'intermédiaire d'une bande de liaison (39), de préférence par l'intermédiaire d'une bande de liaison commune.

4. Moteur à ultrasons selon les revendications 1 ou 2, **caractérisé en ce que** chacune des parties de butée (7) comprend une partie de base et deux parties de paroi (41) contre lesquelles l'actionneur (1) vient en butée avec sa surface latérale respective (19), chaque partie de paroi (41) étant reliée à la partie de base par au moins une nervure de liaison (39), de préférence par une nervure de liaison commune, et une nervure de fixation (43).

5. Moteur à ultrasons selon les revendications 3 ou 4, **caractérisé en ce que** la fréquence de résonance Fs d'au moins une partie d'aile (38) ou d'au moins une partie de paroi (41) est égale ou supérieure à la fréquence de fonctionnement Fa de l'actionneur (1).

6. Moteur à ultrasons selon l'une des revendications 3 à 5, **caractérisé en ce que** l'actionneur (1) est disposé par rapport aux parties de contact (7) de telle manière que chaque barrette de liaison (39) et/ou chaque barrette de fixation (43) se trouve dans la plage de la vitesse minimale respective des vibrations de déformation se formant sur la surface latérale respective (19) de l'actionneur (1) pendant le fonctionnement.

7. Moteur à ultrasons selon l'une des revendications précédentes, **caractérisé en ce que** l'actionneur (1) est disposé par rapport aux leviers d'angle de rotation (51) de telle sorte que le point de contact respectif entre l'un des bras de levier de pression (53) et l'actionneur (1) se trouve dans la plage du minimum de vitesse respectif des vibrations de déformation se formant sur la surface latérale respective (20) de l'actionneur (1) pendant le fonctionnement.
